# EUROPEAN PATENT SPECIFICATION

(11) **EP 2 973 981 B1**
(45) Date of publication and mention of the grant of the patent: **16.05.2018**
(21) Application number: 14715853.9
(22) Date of filing: 12.03.2014
(51) Int. Cl.: H02N 2/00, G03F 7/20, H02N 2/02

(54) **PIEZO DRIVE UNIT**
PIEZOELEKTRISCHE ANTRIEBSEINHEIT
UNITÉ DE COMMANDE PIÉZOÉLECTRIQUE

(30) Priority: 15.03.2013 WO PCT/EP2013/055484
(43) Date of publication of application: 20.01.2016
(73) Proprietor: Heinmade B.V., 5504 PA Veldhoven (NL)
(72) Inventor: SCHELLENS, Hein, 5571 PT Bergeijk (NL); LENSSEN, Bo, 5613 HN Eindhoven (NL); HEEREN, Maikel, 4711 PT Sint Willebrord (NL); DECKX, Johan, 3940 Hechtel-Eksel (BE); BROM, Jeroen, 5554 EW Valkenswaard (NL)
(74) Representative: EIP
(86) International application number: PCT/EP2014/054904
(87) International publication number: WO 2014/140143

(56) References cited:
- DE-A1- 10 117 465
- DE-A1-102006 039 821
- JP-A- H02 223 389
- JP-A- 2006 149 083

## Description

### Technical Field

The present invention relates to a piezo drive unit which is capable of displacing a moving member relative to a holder.

### Background

A piezo drive unit is disclosed in patent application WO2004/066405. The unit includes a plurality of piezo actuators arranged between a support element or holder and the surface of a moving member. To reduce spurious movements of the moving member in the direction of motion caused by deformation of the holder, the stack of each actuator is divided into two stacks parts and the actuators are mutually connected by an element at the height where the two stack parts are joined to increase the stiffness of the actuators. A disadvantage of the known piezo drive unit is the additional extra cost caused by the connecting element.

JP H02 223389 A relates to a stepping motor. Rotary displacement or speed is controlled through variation of source voltage or frequency. The stepping motor comprises two longitudinal vibration elements that operate with reverse phase to each other.

DE 101 17 465 A1 relates to a piezoelectric drive with two groups of clamping piezopackets and two groups of stepping piezopackets. Each group is provided by a piezoelement stack.

JP 2006 149083 A relates to an actuator configured for linear and rotational movement.

DE 10 2006 039821 A1 relates to a projection exposure device for microlithography. The device has an actuator with a linear drive configured as a direct drive.

### Summary

In accordance with the present invention, there is provided a piezo drive unit comprising a holder, a moving member and at least a first and a second actuator connected to the holder at a first and second position according to the independent device claim 1. The reduced distance between the holder and the surface of the moving member at the second position increases the stiffness of the piezo drive unit without the cost of an additional element as required in the prior art. It also permits to increase the thickness of the holder at the second position without increasing the overall size of the holder. The latter advantage is important when the space for the piezo drive unit is restricted by building height constraints. The two actuators are preferably arranged on the same side of the moving member and are advantageously adjacent.

A further aspect of the invention relates to a piezo drive unit comprising a holder having a first section and a second section, a moving member and at least two actuators connected to the first section for interacting with a surface of the moving member and displacing the moving member relative to the first section, wherein the first section includes a part proximate to the surface and a part distal to the surface, the second section is connected to a support for mounting the piezo drive unit, and the second section is connected by a first flexible hinge to the proximate part of the first section.

The distortion of the first section of the holder during operation of the drive unit is less when the first section is connected to the second section at the proximate part rather than at the distal part of the first section. The location of the connection reduces the torque exerted on the first section when an external force acts on the moving member, which reduces the distortion of the first section.

A still further aspect of the invention relates to a piezo drive unit comprising a holder, a moving member, a first actuator including a clamp element, and a second actuator, both actuators being connected to the holder for interacting with a surface of the moving member and displacing the moving member relative to the holder, wherein, in a non-actuated state the first actuator is not in frictional contact with the surface and the second actuator is in frictional contact with the surface.

In the prior art application WO2004/066405 all actuators are in frictional contact with the surface in the non-actuated state. The arrangement of the actuators according to the invention allows the first actuator to be operated by a single-polarity voltage and permits two-channel operations of the drive unit for a stepped mode and analog mode of displacing the moving member. The use of a single-polarity voltage permits the use of a lower height piezo element, which increases the stiffness of the drive unit.

Further features and advantages of the invention will become apparent from the following description of preferred embodiments as examples of the invention, given by way of example only, which is made with reference to the accompanying drawings.

### Brief Description of the Drawings

Figure 1 shows a cross-section of a first example of the piezo drive unit;
Figure 2 shows a cross-section of a second example of the piezo drive unit;
Figure 3 shows a perspective drawing of the part of the second example;
Figure 4 shows a cross-section of a third example of the piezo drive unit;
Figure 5 shows a cross-section of a fourth example of the piezo drive unit; and
Figure 6 shows a schematic diagram of an imaging system for micro lithography.

### Detailed Description

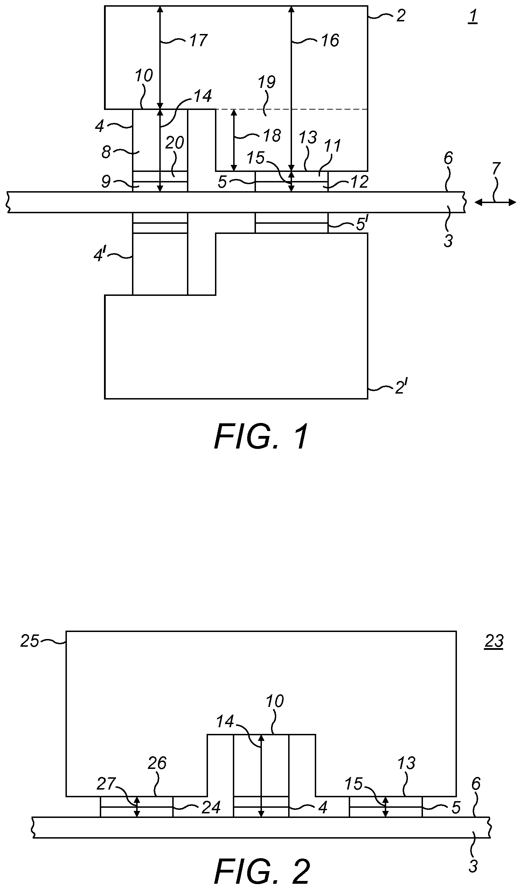

Figure 1 shows a cross-section of an embodiment 1 of a piezo drive unit according to a first aspect of the invention, comprising a holder 2, a moving member 3, a first piezo actuator 4 and a second piezo actuator 5. The actuators are shown in a non-actuated state, i.e. with zero voltage applied, and are in frictional contact with the moving member. During operation the actuators will interact with a surface 6 of the moving member 3 and displace the moving member relative to the holder 2 in a direction in the plane of the surface 6, shown by arrow 7. The holder or the moving member may be stationary or both may move. The first actuator 4 includes a clamp element 8 and a wear resistant end plate 9 and is connected to the holder 2 at a first position 10. The second actuator 5 includes a shear element 11 and a wear resistant end plate 12 and is connected to the holder 2 at a second position 13. The holder is pre-tensioned towards the surface 6 by means not shown in figure 1.

A first distance 14 between the position 10 and the surface 6 is greater than a second distance 15 between the position 13 and the surface 6. The different distances allow a greater thickness of the holder at the position 13 than at the position 10. Prior art piezo drive unit usually have actuators of the same length. Hence, a prior art holder would have a thickness 17 at both position 10 and 13. During operation change of forces caused by the actuators and external forces acting on the moving member will deform the holder, which affects the accuracy of the displacement of the moving member. In a prior art piezo drive unit, this disadvantage can be mitigated by increasing the thickness 17 of the holder. However, building height constraints may limit the extent of the thickness 17.

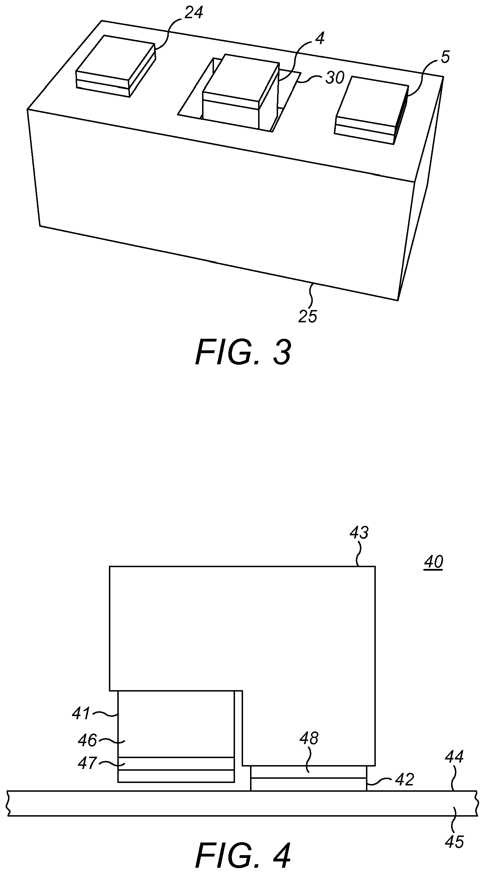

The piezo drive unit according to the invention allows to increase the stiffness of the holder by increasing the thickness at position 13 without increasing the overall height of the holder above the surface 6. It also allows to decrease the overall height of the holder without sacrificing stiffness of the holder. In an exemplary embodiment the height of the first and second actuator is 6 and 2 mm, respectively, the cross-section of both actuators is 6 by 6 mm square; the thickness 17 and 16 of the holder at the positions 10 and 13 of the first and second actuator are 4 and 8 mm, respectively; and the thickness of the holder perpendicular to the plane of the drawing is 12 mm. The increased thickness at the position 13 will reduce deformation of the holder during operation and when the actuators are not actuated. An increase in thickness from 4 to 8 mm will significantly increase the stiffness of the holder in figure 1. The stiffness will increase by a factor of more than 5 in the embodiment described below with reference to figure 3.

The holder 2 in figure 1 is preferably a single component having at least two different thicknesses 16 and 17. The holder may have the shape of a block having a thickness 16 with a hole cut out at position 10 to accommodate the first actuator 4. Alternatively, the holder 2 may comprise two or more parts that are connected such that the assembled holder has the same stiffness as a holder made of one piece. The extra stiffness of the holder according to the invention is achieved by a part 19 of the holder, having a thickness 18 at position 13 and extending beyond the thickness 17 of the holder at position 10. When the cross-section of the part 19 in the plane of the surface 6 is larger than the cross-section of the actuator 5, the part 19 will substantially increase the rigidity of the holder.

The reduced height of the second actuator 5 can be achieved by including only the shear element 11 and an endplate 12 in the actuator. The greater height of the first actuator 4 is required for the clamp element 8, which normally has a greater height than a shear element. Each of the elements 8 and 11 may be a single-layer piezo element, a multi-layer piezo stack or a monolithic multilayer piezo element, also called monolithic co-fired piezo element. The latter piezo element achieves a larger stroke per applied voltage and permits reduction of the distances 14 and 15 between the surface 6 of the moving member 3 and the holder 2.

The piezo drive unit 1 can displace the moving member 3 in known manner, e.g. as disclosed in patent application US2003/0085633. In the non-actuated state both actuators 4 and 5 are in frictional contact with the surface 6 of the moving member 3. In a first step for stepped moving, the actuator 8 is contracted by applying a negative voltage, releasing its end plate 9 from the moving member. An external pre-load on the holder, pressing the holder against the moving member, is acting now on actuator 5 only, which increases the force between the endplate 12 of actuator 5 and the surface 6. In a second step the shear element 11 is actuated and the end plate 12 of the second actuator moves either to the right or left hand side, depending on the polarity of the applied voltage, thereby displacing the moving member in the same direction. In a third step a positive voltage is applied to the first actuator 4 that expands the actuator to come into frictional contact with the moving member and causing the second actuator 5 to release from the moving member without displacing the moving member. In a fourth step the second actuator is moved in a direction opposite to that in the second step without displacing the moving member, as it is not in contact with the moving member during this step. The cycle continues with the above first step.

The changes in the forces caused by the contraction and expansion of the first actuator 4 in the first and third step, respectively, cause a deformation of the holder 2 and the actuator 5, resulting in an undesirable displacement of the moving member 3. The increased stiffness of the relatively short actuator 5 and the increased thickness of the holder 2 both reduce the deformation and, hence, the undesirable displacement of the moving member. The undesirable displacement of the moving member due to operating the clamping element of the actuator 4 is also called 'crosstalk'.

In a special embodiment the first actuator is provided with a shear element 20, which also moves in a direction within the plane of the surface 6. The two shear elements 11 and 20 permit a greater speed of the moving member. The movement cycle is now as follows. First step: contract the clamp element 8. Second step: move the shear element 11 of the second actuator to the left hand side and the shear element 20 of the first actuator to the right hand side, the moving member following the displacement of the second actuator to the left. Third step: expand the clamp element. Fourth step: move the shear elements 11 and 20 in the opposite direction as in the second step, the moving member following the displacement of the first actuator to the left. Continue with the first step. If 'left' and 'right' are interchanged, the moving member will be displaced to the right.

In a further special embodiment of a drive unit having two or more shear elements the shear elements displace in different directions within the plane of the surface 6, for example in two perpendicular directions. It allows displacement of the moving member 3 in two different directions in the second and fourth step of the preceding paragraph.

The piezo drive unit can displace the moving member over small distances in a so-called analog mode, in contrast with the above stepping modes. In the analog mode the actuator with the shear element is constantly in frictional contact with the moving member. The moving member is displaced by changing the voltage on the shear element. The movement in this mode is limited to the maximum stroke of the shear element. During the analog mode actuators not having a shear element should be contracted to release from the moving member. If all actuators have a shear element, all actuators may contact the moving member and can be driven synchronously in the same direction.

When a drive unit with a shear element in all actuators must be able to operate in both the stepped mode and the analog mode, three electrical channels are normally used to drive the actuators: one for the clamp element 8, one for the shear element 11 and one for the shear element 20. Two channels are required for the shear elements, because they are moved in opposite directions during stepped motion and in the same direction during analog motion. A two-channel operation is possible, when the clamp element is contracted during the analog mode and the stepping is done by the shear element of the short actuator only. A disadvantage of this two-channel operation is that during the entire analog mode a relatively high voltage must be applied to the clamp element to keep the first actuator released from the moving member. This reduces the lifetime of the first actuator.

Figure 2 shows an embodiment of the drive unit 23 similar to that of figure 1, but with a third actuator 24 added. The third actuator is connected to a holder 25 at a position 26. A third distance 27 between the position 26 and the surface 6 is smaller than the first distance 14. The third distance 27 may be equal to the second distance 15 within manufacturing tolerances to facilitate the production of the drive unit. The third actuator 24 can be operated synchronously with the second actuator 5. This embodiment has two positions with a shorter distance from the holder to the surface and one position having a longer distance from the holder to the surface and permits a combination of a clamping element and two shear elements. The added actuator improves the control of the displacement of the moving member. The moving member 3 may move in the plane of the drawing as in Figure 1 or perpendicular to the plane of the drawing.

The three actuators may be arranged in various configurations. Figure 2 shows a configuration where the first position 10 is located between the second position 13 and the third position 26. The configuration includes a clamp element having a shear element at both sides, the symmetry of which provides less distortion of the holder during operation and a smoother motion of the moving member 3. The holder 25 can be a block having a hole at position 10 for the longer actuator. Figure 3 shows a perspective drawing of such a block, inverted in view figure 2, with a hole 30 holding the first actuator 4 and two actuators 5 and 24 arranged on a face of the block; in the embodiment of figure 3 the first actuator has no shear element.

The force on the moving member 6 may be increased by using more actuators. The combination of the longer actuator 4 and shorter actuator 5 in figure 1 can be repeated in the direction of the moving member. For example, the holder may have four actuators in the order longer, shorter, longer, shorter. Configurations having an odd number of actuators are also possible, for example longer, shorter, longer, or shorter, longer, shorter, longer, shorter. The configurations may have longer series of actuators. All shorter actuators may be operated with the same applied voltage. Likewise, all longer actuators may be operated with the same applied voltage. Any shear elements in the longer actuators may also be operated with the same applied voltage.

In the embodiments described with reference to figures 1 and 2, the moving member 3 is displaced in the direction of a line connecting the actuators. Alternatively, the moving member may be displaced in a direction perpendicular to the line connecting the actuators. In figure 2 this amounts to the shear elements in the actuators 5 and 24 and optionally 4 not moving in the plane of the drawing but perpendicular to it; the moving member 3 will also be displaced in a direction perpendicular to plane of the drawing.

Instead of forming a linear array, the configuration of actuators may also form a two-dimensional array, further reducing the undesirable displacement of the moving member by an increased stiffness. For example, four actuators may be arranged at the corners of a square in the plane of the surface 6, two long actuators on one diagonal, two short actuators on the other diagonal. A long actuator may also be surrounded by three short actuators arranged in a triangle.

In each of the above embodiments, having a one-dimensional or two-dimensional array of actuators, optionally two or more further actuators may be arranged opposite with respect to the moving member 3. Two opposing actuators have preferably the same functionality. The arrangement of actuators on both sides of the moving member increases the symmetry of the drive unit and thereby reduces the distortion of the holder. Moreover, it obviates the need for a support of the moving member 3 that can take up the force of the actuators pressing against the other side of the moving member. When the arrangement of the actuators on both sides of the moving member is symmetrical, torque on the holder and moving member is reduced. In the arrangement a long actuator on one side of the moving member may face another long actuator on the other side. Alternatively, a long actuator on one side may face a short actuator on the other side. The actuators on both sides may be operated synchronously to reduce further torque on the holder and moving member.

Figure 1 shows two such optional actuators 4' and 5' connected to a holder 2'. In fact, the holder of the drive unit is now constituted by a first part 2 and a second part 2'. The actuators 4' and 5' are opposite the actuators 4 and 5, respectively, with respect to the moving member 3. The actuators 4' and 5' increase the driving force on the moving member 3 and reduce demands on or removes the need for guides to keep the moving member 3 between the parts 2 and 2' of the holder in the plane of the drawing.

Figure 4 shows an embodiment 40 of the piezo drive unit according to a second aspect of the invention. A first and second actuator 41 and 42 are connected to a holder 43 for interacting with a surface 44 of a moving member 45 and displacing the moving member relative to the holder. In a non-actuated state the first actuator 41 is not in frictional contact with the surface 44 and the second actuator 42 is in frictional contact with the surface 44. The first actuator includes a clamp element 46 and an optional shear element 47; the second actuator includes a shear element 48.

The moving member 45 can be stepped in a manner similar to the two methods described above, one without and one with the shear element 47. However, the retraction of the long actuator in the embodiments of figure 1 and 2 by applying a negative voltage in the first step to release it from the moving member can be omitted; instead a zero voltage is applied to the clamp element 46 of the actuator. Hence, the clamp piezo element can be operated with a single-polarity positive voltage, which reduces the risk of depolarising the piezo material of the clamp element. A monolithic multilayer piezo is very suitable for operation with a single-polarity voltage.

In the analog mode, the embodiment of figure 4 does not require application of a high negative voltage to the clamp element, in contrast with the embodiment of figure 1. Hence, a two-channel operation of the drive unit is possible without affecting the lifetime of the first actuator in the analog mode. The voltage on the clamp piezo can be zero in the analog mode.

Since the clamp piezo can be operated with a single-polarity positive voltage only, the stack may be used at a higher displacement per mm stack height than in dual-polarity use with a single channel for clamping as disclosed in patent application US2003/0085633. Hence, the required stroke can be attained with a stack of less height, which improves the stiffness of the drive unit. The increased stiffness reduces the deformation of the holder and actuators and, hence, reduces the stroke of the clamp element required to release the moving member. The reduced stroke in turn permits the use of an even shorter actuator, which again improves the stiffness.

The feature of a first actuator that does not contact the moving member in the non-actuated state can be used in any multi-actuator piezo drive unit, in particular in the embodiments according to the invention, and including a drive unit having two or more actuators of the same height, providing the possibility of two-channel operation for stepped and analog motion. The feature is particularly suitable for the piezo drive units having the different distances between the holder and the moving member, because of the high stiffness of the holder, which compensates any reduced stiffness caused by the first actuator not being in contact with the moving member in the non-actuated state.

The cross-section of the actuators 41 and 42 in the embodiment of figure 4 is larger than in the embodiments of figures 1, 2 and 3. The increased cross-section improves the stiffness of the actuators, which reduces the deformation of the holder 43. The distance between adjacent actuators is preferably less than half the diameter of an actuator along the line connecting the actuators, more preferably less than 2 mm; e.g. two 6x6 mm piezos arranged at 1 mm distance. The larger cross-section actuators can be used in any of the embodiments according to the invention.

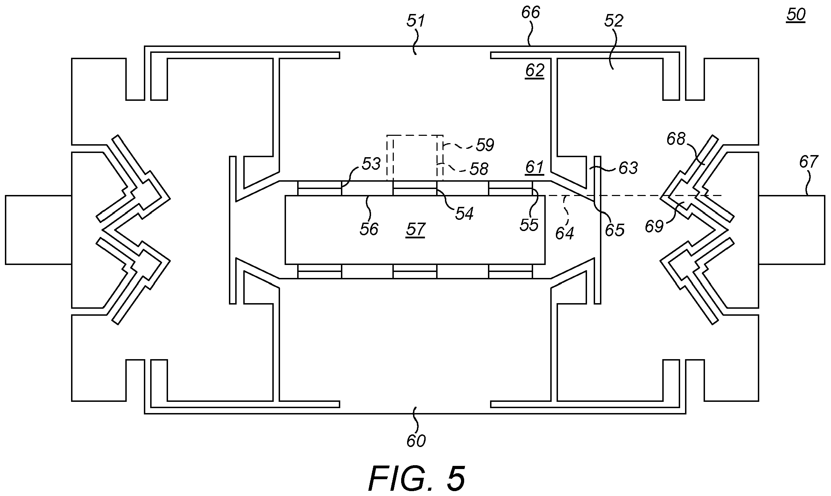

Figure 5 shows an embodiment 50 of the piezo drive unit according to a third aspect of the invention. The unit has a holder including a first section 51 and a second section 52. At least two actuators, in the embodiment shown three actuators 53, 54 and 55, are connected to the first section 51 for interacting with a surface 56 of a moving member 57. In the embodiment of figure 5 the displacement of the moving member is in a direction perpendicular to the plane of the drawing. The actuators may be of a type and arranged as in known piezo drive units. The above type and arrangement of the actuators described with reference to any one of the figures 1 to 4 is very suitable for use in this piezo drive unit. Figure 5 shows such an arrangement by the dashed lines 58, indicating the position of the actuator 54 in a hole 59 of the first section 51.

The holder may have an optional further first section 60 with three actuators, which makes the driving of the moving member 57 more symmetrical.

The first section 51 has a part 61 proximate to the surface 56 and a part 62 distal to the surface. The proximate part is the part of the section 51 that faces the surface 56 of the moving member.

Forces due to the shear operation of the actuators 53-55 and forces from the moving member 57 act on the proximate part 61 of the first section 51. In prior art drive units the first section is connected to the second section 52 near the distal part 62. As a consequence the forces acting near the proximate part will cause a torque over the height of the first section 51, which may deform the first section.

According to the third aspect of the invention, the second section 52 is connected by a first flexible hinge 63 to the proximate part 61 of the first section 51. Since the forces acting on the first section 51 are diverted to the second section 52 at the same height where they act, the moment on the first section will be reduced substantially and with that the deformation of the first section. When the arrangement of actuators of the embodiments shown in figures 1 to 4 is used in the embodiment of figure 5, the location of the first hinge near the proximate part 61 has an increased relevance because the proximate part and the distal part are further apart than for prior art arrangements, due to the height difference 18 in figure 1. As shown in figure 5, a further first hinge is arranged on the other side of the first section 51. When the driving of the moving member is made symmetric, as shown in the figure, the further first section 51 may also be provided with first hinges connected to the proximal part 61 of the first section 51.

The flexible first hinge 63 of the embodiment of figure 5 is V-shaped and has a pole 65 substantially in a plane 64 of the surface 56, shown by a dashed line. This location of the pole further reduces the torque created by external forces acting on the first section 51. A reduced moment further improves the performance of the drive unit, since the deformation of the holder is reduced, which allows a shorter stroke and lower voltage necessary to operate the actuator 54. A shorter stroke at similar electrical fields permits a shorter actuator and a subsequent further increase in stiffness of the holder and actuators can be achieved, which further reduces the crosstalk of the moving member. The above advantage of reducing the deformation of the holder applies to all embodiments of the present invention.

The first hinge 63 connected to the proximal part of the first section 51 also improves the shock-resistance of the drive unit by reducing any bending of the piezo elements. This is important in particular when the moving member is attached to a relatively heavy component that may exert large forces on the moving member, e.g. during transport.

The actuators may be pre-tensioned towards the moving member 57 by a flexible connection 66 connecting the distal part 62 of the first section 51 to the second section 52. The tension can be set by mounting the connection under tension during manufacture of the drive unit.

The second section 52 is connected to a support 67 for mounting the piezo drive unit 50 in an apparatus. The drive unit is also connected to the apparatus by the moving member. The support may be rigidly connected to the second section or form part of the second section. A misalignment of the drive unit and / or the apparatus may distort the second section. The distortion will be substantially reduced if the support 67 is connected to the second section 52 by a second flexible hinge 68, which decouples the support from the second section.

The hinge 68 of the embodiment 50 is V-shaped and has a pole 69 substantially in the plane 64 of the moving member 57, which further reduces moments exerted on the first section, thereby reducing wear of the drive unit.

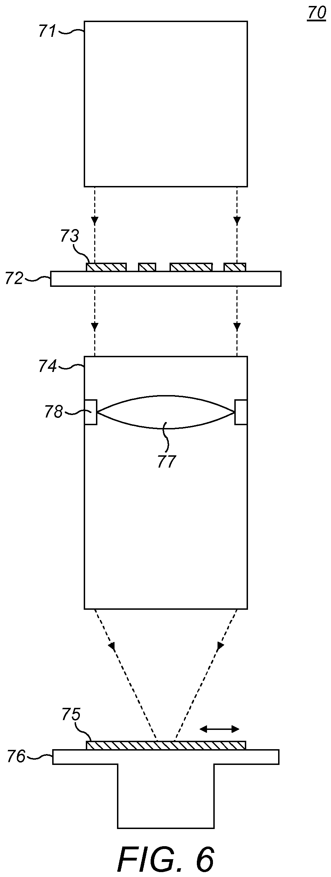

Figure 6 shows a schematic diagram of an apparatus 70 in which the piezo drive unit is used. The apparatus is a micro lithographic projection device for microlithography as known in the art, in which the piezo drive unit according to the invention can be used. The projection device includes a light source 71, a device 72 for accepting and aligning a mask 73 provided with a pattern, an optical unit 74 for imaging the pattern onto a wafer 75. The wafer is arranged on a device 76 for positioning and moving the wafer 75. The optical unit includes a plurality of optical elements such as mirrors and/or lenses, one of which, 77, is shown in the figure, arranged in a mounting 78.

During operation of the projection device 70 the position of one or more of the lenses and / or the mask may be controlled to optimize the imaging properties of the system when e.g. the air pressure or the temperature in the imaging system changes. Patent application WO2003/052511 discloses such a control by a piezo drive unit. The piezo drive unit according to the present invention is very suitable for controlling the position of an optical element such as a lens or a mirror in an imaging system.

The piezo drive unit can also be used in a device used for a micro lithographic production process, e.g. for positioning wafers within a device for measuring, inspecting or machining of wafers or masks.

The high positioning accuracy of the piezo drive unit according to the present invention due to the low distorting of the holder makes the drive unit appropriate for use in nano-positioning apparatuses, e.g. atomic force microscopes or scanning electron microscopes.

The above embodiments are to be understood as illustrative examples of the invention. Further embodiments of the invention are envisaged. Although the above embodiments disclose a displacement of the moving member along a straight line, a displacement along a curved line is also feasible, for example by having a moving member in the form of a rotatable disc. It is to be understood that any feature described in relation to any one embodiment may be used alone, or in combination with other features described, and may also be used in combination with one or more features of any other of the embodiments, or any combination of any other of the embodiments. Furthermore, equivalents and modifications not described above may also be employed without departing from the scope of the invention, which is defined in the accompanying claims.

## Claims

1. A piezo drive unit (50) comprising a holder, a moving member (57) and at least a first and a second actuator (53, 54) connected to the holder for interacting with a plane of the surface of the moving member and displacing the moving member relative to the holder, wherein:
the holder has a first section (51) and a second section (52); the first and second actuators (53, 54) are connected to the first section;
the first section includes a part (61) proximate to the surface and a part (62) distal to the surface;
the second section is connected to a support (67) for mounting the piezo drive unit; and **characterized in that** the second section is connected by a first flexible hinge (63) to the proximate part of the first section.

2. A piezo drive unit according to claim 1, wherein:
the first actuator and the second actuator are connected to the holder at a first and second position, respectively, and the displacing the moving member is in a direction parallel or perpendicular to a line connecting the first and second actuator where they interact with the moving member;
a thickness of the holder at the second position is greater than a thickness of the holder at the first position;
a first distance between the first position and the surface is greater than a second distance between the second position and the surface; and
the first actuator includes a clamp element and the second actuator includes a shear element, the first actuator being arranged for releasing the second actuator from the moving member.

3. A piezo drive unit according to claim 2, in which the first actuator includes a shear element.

4. A piezo drive unit according to claim 2 or claim 3, including a third actuator connected to the holder at a third position, the third position having a third distance to the surface that is smaller than the first distance.

5. A piezo drive unit according to claim 4, in which the first position is located between the second and third positions.

6. A piezo drive unit according to any one of claims 2 to 5, including at least two further actuators arranged opposite to the first and second actuator, respectively, with respect to the moving member, the arrangement of the actuators on both sides of the moving member being preferably symmetrical.

7. A piezo drive unit according to any preceding claim, in which the first hinge is V-shaped and has a pole substantially in a plane of the surface, the support is preferably connected to the second section by a second flexible hinge, and preferably the second hinge is V-shaped and has a pole substantially in a plane of the surface.

8. A piezo drive unit according to any preceding claim, wherein:
the first actuator includes a, or the, clamp element; and
in a non-actuated state the first actuator is configured to not be in frictional contact with the surface and the second actuator is configured to be in frictional contact with the surface.

9. A piezo drive unit according to claim 8, in which the second actuator includes a shear element, and the first actuator includes preferably a shear element.

10. An apparatus including a component, a moving member and a piezo drive unit according to any one of claims 1 to 9, in which the piezo drive unit is arranged to control a position of the component.

11. An apparatus according to claim 10, wherein the component is an optical element, and the apparatus is preferably adapted for use in an microlithographic production process, the apparatus being for example a microlithographic projection device.

12. An apparatus according to claim 10 or 11 adapted for use in a field different from microlithographic production processes.

13. Use of a piezo drive unit according to any one of claims 1 to 9 in an apparatus adapted for or not adapted for a microlithographic production process.

## Patentansprüche

1. Piezo-Antriebseinheit (50) mit einem Halter, einem beweglichen Element (57) und mindestens einem ersten und einem zweiten Aktuator (53, 54), die mit dem Halter verbunden sind, um mit einer Ebene der Oberfläche des beweglichen Elements zu interagierten und das bewegliche Element relative zu dem Halter zu verschieben, wobei
der Halter einen ersten Abschnitt (51) und einen zweiten Abschnitt (52) aufweist;
der erste und zweite Aktuator (53, 54) mit dem ersten Abschnitt verbunden sind;
der erste Abschnitt einen Teil (61) in der Nähe der Oberfläche und einen Teil (62) in Entfernung zur Oberfläche umfasst;
der zweite Abschnitt mit einem Träger (67) zur Befestigung der Piezo-Antriebseinheit verbunden ist;
und **dadurch gekennzeichnet, dass**
der zweite Abschnitt durch ein erstes flexibles Gelenk (63) mit dem nahen Teil des ersten Abschnitts verbunden ist.

2. Piezo-Antriebseinheit nach Anspruch 1, wobei der erste Aktuator und der zweite Aktuator an einer ersten bzw. zweiten Position mit dem Halter verbunden sind und die Verschiebung des beweglichen Elements in einer Richtung parallel oder senkrecht zu einer Linie verläuft, die den ersten und zweiten Aktuator verbindet, wo sie mit dem beweglichen Element interagieren;
eine Dicke des Halters an der zweiten Position größer ist als eine Dicke des Halters an der ersten Position;
ein erster Abstand zwischen der ersten Position und der Oberfläche größer ist als ein zweiter Abstand zwischen der zweiten Position und der zweiten Oberfläche; und
der erste Aktuator ein Klemmelement und der zweite Aktuator ein Scherelement umfasst, wobei der erste Aktuator so angeordnet ist, dass er den zweiten Aktuator von dem beweglichen Element löst.

3. Piezo-Antriebseinheit nach Anspruch 2, bei der der erste Aktuator ein Scherelement umfasst.

4. Piezo-Antriebseinheit nach Anspruch 2 oder Anspruch 3, mit einem dritten Aktuator, der mit dem Halter in einer dritten Position verbunden ist, wobei die dritte Position einen dritten Abstand zur Oberfläche aufweist, der kleiner als der erste Abstand ist.

5. Piezo-Antriebseinheit nach Anspruch 4, bei der sich die erste Position zwischen der zweiten und dritten Position befindet.

6. Piezo-Antriebseinheit nach einem der Ansprüche 2 bis 5 mit mindestens zwei weiteren Aktuatoren, die gegenüber dem ersten bzw. zweiten Aktuator in Bezug auf das bewegliche Element angeordnet sind, wobei die Anordnung der Aktuatoren auf beiden Seiten des beweglichen Elements vorzugsweise symmetrisch ist.

7. Piezo-Antriebseinheit nach einem der vorhergehenden Ansprüche, bei der das erste Gelenk V-förmig ist und einen Pol im Wesentlichen in einer Ebene der Oberfläche aufweist, der Träger vorzugsweise durch ein zweites flexibles Gelenk mit dem zweiten Abschnitt verbunden ist und vorzugsweise das zweite Gelenk V-förmig ist und einen Pol im Wesentlichen in einer Ebene der Oberfläche aufweist.

8. Piezo-Antriebseinheit gemäß einem der vorhergehenden Ansprüche, wobei:
der erste Aktuator ein oder das Klammerelement umfasst; und
im unbetätigten Zustand der erste Aktuator so ausgebildet ist, dass er keinen Reibkontakt mit der Oberfläche hat und der zweite Aktuator so eingerichtet ist, dass er einen Reibekontakt mit der Oberfläche hat.

9. Piezo-Antriebseinheit nach Anspruch 8, bei der der zweite Aktuator ein Scherelement umfasst und der erste Aktuator vorzugsweise ein Scherelement umfasst.

10. Vorrichtung, die ein Bauteil, ein bewegliches Element und eine Piezo-Antriebseinheit nach einem der Ansprüche 1 bis 9 umfasst, wobei die Piezo-Antriebseinheit so angeordnet ist, dass sie eine Position des Bauteils steuert.

11. Vorrichtung nach Anspruch 10, wobei das Bauteil ein optisches Element ist und die Vorrichtung vorzugsweise für die Verwendung in einem mikrolithografischen Herstellungsverfahren eingerichtet ist, wobei die Vorrichtung zum Beispiel ein mikrolithografisches Projektionsgerät ist.

12. Vorrichtung nach Anspruch 10 oder 11, die eingerichtet ist, in einem Bereich, der unterschiedlich zu einem mikrolithografischen Herstellungsverfahren ist, verwendet zu werden.

13. Verwendung einer Piezo-Antriebseinheit nach einem der Ansprüche 1 bis 9 in einer Vorrichtung, die für ein mikrolithografisches Herstellungsverfahren eingerichtet oder nicht eingerichtet ist.

## Revendications

1. Unité de commande piézo-électrique (50) comprenant un dispositif de maintien, un élément mobile (57) et au moins des premier et deuxième actionneurs (53, 54) reliés au dispositif de maintien de façon à interagir avec un plan de la surface de l'élément mobile et à déplacer l'élément mobile par rapport au dispositif de maintien, dans lequel :
le dispositif de maintien comporte une première section (51) et une seconde section (52) ;
les premier et deuxième actionneurs (53, 54) sont reliés à la première section ;
la première section comprend une partie (61) proximale à la surface et une partie (62) distale à la surface ;
la seconde section est reliée à un support (67) de montage de l'unité de commande piézo-électrique ; et
**caractérisée en ce que** la seconde section est reliée, par une première charnière souple (63), à la partie proximale de la première section.

2. Unité de commande piézo-électrique selon la revendication 1, dans laquelle :
le premier actionneur et le deuxième actionneur sont reliés au dispositif de maintien au niveau respectivement de première et deuxième positions, et le déplacement de l'élément mobile se fait dans une direction parallèle ou perpendiculaire à une ligne reliant les premier et deuxième actionneurs où ils interagissent avec l'élément mobile ;
une épaisseur du dispositif de maintien au niveau de la deuxième position est supérieure à une épaisseur du dispositif de maintien au niveau de la première position ;
une première distance séparant la première position et la surface est supérieure à une deuxième distance séparant la deuxième position et la surface ; et
le premier actionneur comprend un élément de serrage et le deuxième actionneur comprend un élément de cisaillement, le premier actionneur étant agencé de façon à libérer le deuxième actionneur de l'élément mobile.

3. Unité de commande piézo-électrique selon la revendication 2, dans laquelle le premier actionneur comprend un élément de cisaillement.

4. Unité de commande piézo-électrique selon la revendication 2 ou la revendication 3, comprenant un troisième actionneur relié au dispositif de maintien au niveau d'une troisième position, la troisième position se trouvant à une troisième distance par rapport à la surface qui est inférieure à la première distance.

5. Unité de commande piézo-électrique selon la revendication 4, dans laquelle la première position est située entre les deuxième et troisième positions.

6. Unité de commande piézo-électrique selon l'une quelconque des revendications 2 à 5, comprenant au moins deux autres actionneurs disposés opposés respectivement aux premier et deuxième actionneurs par rapport à l'élément mobile, l'agencement des actionneurs des deux côtés de l'élément mobile étant de préférence symétrique.

7. Unité de commande piézo-électrique selon l'une quelconque des revendications précédentes, dans laquelle la première charnière a une forme de V dont un pôle est situé sensiblement dans un plan de la surface, le support est de préférence relié à la seconde section par une seconde charnière souple et, de préférence, la seconde charnière a une forme de V dont un pôle est situé sensiblement dans un plan de la surface.

8. Unité de commande piézo-électrique selon l'une quelconque des revendications précédentes, dans laquelle :
le premier actionneur comprend un élément de serrage, ou l'élément de serrage ; et
dans un état non actionné, le premier actionneur est conçu pour ne pas se trouver en contact de friction avec la surface et le deuxième actionneur est conçu pour se trouver en contact de friction avec la surface.

9. Unité de commande piézo-électrique selon la revendication 8, dans laquelle le deuxième actionneur comprend un élément de cisaillement, et le premier actionneur comprend de préférence un élément de cisaillement.

10. Appareil comprenant un composant, un élément mobile et une unité de commande piézo-électrique selon l'une quelconque des revendications 1 à 9, dans lequel l'unité de commande piézo-électrique est conçue pour commander une position du composant.

11. Appareil selon la revendication 10, dans lequel le composant est un élément optique, et l'appareil est de préférence prévu pour une utilisation dans un traitement de production microlithographique, l'appareil étant par exemple un dispositif de projection microlithographique.

12. Appareil selon la revendication 10 ou 11, dans lequel l'appareil est prévu pour une utilisation dans un domaine différent des traitements de production microlithographique.

13. Utilisation d'une unité de commande piézo-électrique selon l'une quelconque des revendications 1 à 9 dans un appareil prévu, ou non, pour un traitement de production microlithographique.
